Europäisches Patentamt

**European Patent Office**

**Office européen des brevets**

(11) Veröffentlichungsnummer: **0 441 126 A2**

## (12) EUROPÄISCHE PATENTANMELDUNG

(21) Anmeldenummer: **91100273.1**

(22) Anmeldetag: **10.01.91**

(51) Int. Cl.5: **H03K 19/003**

(30) Priorität: **06.02.90 DE 4003560**

(43) Veröffentlichungstag der Anmeldung:
**14.08.91 Patentblatt 91/33**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Stein, Christian**
**Reinekestrasse 22**
**W-8000 München 90(DE)**
Erfinder: **Guggenmos, Xaver, Dipl.-Ing.**
**Joh.-Seb.Bach-Weg 11**
**W-8060 Dachau(DE)**
Erfinder: **Krause, Joachim, Dipl.-Ing.**
**Wilhm.-v.-Kaulbach-Weg 48**
**W-8300 Landshut(DE)**

(54) **Schaltungsanordnung zum Schutz von Anschlüssen integrierter Schaltkreise.**

(57) ESD-Schutz-Schaltungsanordnung für Ausgänge
(11) von integrierten Schaltkreisen mit Transistoren
(20,21) gleichen Typs, die zwischen den Anschlüssen (11) und Versorgungspotentialen ($V_{ss}$, $V_{dd}$) liegen.

FIG 4

EP 0 441 126 A2

## SCHALTUNGSANORDNUNG ZUM SCHUTZ VON ANSCHLÜSSEN INTEGRIERTER SCHALTKREISE

Die vorliegende Erfindung betrifft eine Schaltungsanordnung zum Schutz von Anschlüssen integrierter Schaltkreise nach dem Oberbegriff des Patentanspruches 1.

Im Rahmen vorliegender Erfindung umfaßt der Begriff "Anschluß" sowohl Eingänge, Ausgänge, kombinierte Ein-/Ausgänge als auch Versorgungspotentialanschlüsse.

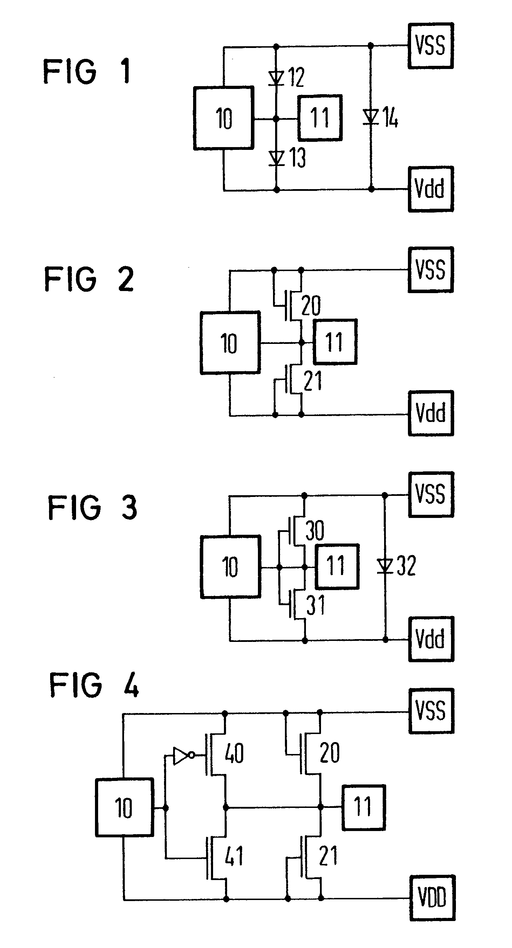

Schaltungsanordnungen der gattungsgemäßen Art sind bekannt. Ihr prinzipieller Aufbau ist in den FIG 1 bis 3 dargestellt. Diese FIG zeigen jeweils schematisch einen integrierten Schaltkreis 10, bei dem es sich um einen CMOS-Schaltkreis handelt, mit Versorgungspotential-Anschlüssen, die wie üblich mit $V_{ss}$ und $V_{dd}$ bezeichnet sind. Ein schematisch dargestellter Ausgang des integrierten Schaltkreises 10 ist mit 11 bezeichnet.

Zum Schutz gegen elektrostatische Spannungen am Ausgang 11 zeigen die FIG 1 bis 3 jeweils Nebenschlußwege, die in FIG 1 durch Dioden 12 bis 14, in FIG 2 durch MOS-Transistoren 20 und 21 und in FIG 3 durch eine Kombination aus Dickoxid-Transistoren 30,31 und eine Diode 32 gebildet sind. Eine Ausführungsform nach FIG 1 ist beispielsweise aus "Electrostatic Discharge Control", von Tarak N. Bhar und Edward J. McMahon, New Jersey, 1983, Seiten 82 und 83 bekannt.

Bisher wurden die MOS-Ableittransistoren 20 und 21 für CMOS-Schaltkreise gemäß FIG 2 als Transistoren mit unterschiedlichem Kanaltyp ausgebildet, wie dies beispielsweise aus "Electrical Overstress Protection for Electronic Devices" von Robert Antinone (New Jersey, 1986), Teil II, Anhang H bekannt ist.

Der Erfindung zugrundeliegende Untersuchungen haben gezeigt, daß sich bei Verwendung von MOS-Transistoren unterschiedlichen Kanaltyps ein unterschiedliches Ansprechverhalten der Transistoren und damit ein schlechter Schutz gegen elektrostatische Spannungen (ESD-Schutz) ergibt.

Der vorliegenden Erfindung liegt die Aufgabe zugrunde, eine Schaltungsanordnung der in Rede stehenden Art mit besserem ESD-Schutzverhalten für integrierte Schaltkreiser, insbesondere CMOS-Schaltkreise, anzugeben.

Diese Aufgabe wird bei einer Schaltungsanordnung der eingangs genannten Art erfindungsgemäß nach dem kennzeichnenden Teil des Patentanspruches 1 gelöst.

Weiterbildungen der erfindungsgemäßen Schaltungsanordnung sind Gegenstand von Unteransprüchen.

Die Erfindung wird im folgenden anhand von Ausführungsbeispielen gemäß den FIG der Zeichnung näher erläutert. Es zeigt:

FIG 1 bis 3      jeweils ein Schaltbild der bereits erläuterten bekannten Ausführungsformen einer Schutz-Schaltungsanordnung; und

FIG 4      ein Schaltbild einer besonderen Ausführungsform einer erfindungsgemäßen Schutz-Schaltungsanordnung.

In FIG 4, in der gleiche Elemente wie in den FIG 1 bis 3 mit gleichen Bezugzeichen versehen sind, besitzen die Transistoren 20 und 21 in den Hebenschlußfaden zwischen dem Ausgang 11 und den Versorgungspotential-Anschlüssen $V_{ss}$ und $V_{dd}$ erfindungsgemäß gleichen Kanaltyp, wobei es sich insbesondere um n-Kanal-Transistoren handelt. Die Verwendung von n-Kanal-Transistoren ist insbesondere deshalb von Vorteil, weil das Ansprechen dieser Transistoren bei Überlastung des integrierten Schaltkreises 10 durch elektrostatische Spannungen am Ausgang 11 aufgrund von Lawineneffekten zustande kommt, so daß sich für n-Kanal-Transistoren gegenüber p-Kanal-Transistoren ein schnelleres Ansprechen ergibt.

Die Ableittransistoren besitzen also eine npn-Struktur, wobei es sich erfindungsgemäß nicht ausschließlich um MOS-Transistoren handeln muß. Es kann sich ebenso um Bipolartransistoren handeln.

In der Schaltungsanordnung nach FIG 4 ist darüber hinaus eine Weiterbildung dargestellt, bei der ein üblicherweise im integrierten Schaltkreis 10 vorhandener Ausgangstreiber mit Transistoren 40,41 eigens dargestellt ist. Durch diesen Ausgangstreiber kann die ESD-Schutzwirkung weiter verbessert werden, wenn die Transistoren 40,41 gleichen Typ besitzen, wobei es sich insbesondere wiederum um n-Kanal-MOS-Transistoren oder npn-Bipolartransistoren handelt. Um einen p-Kanal-Transistor in einem herkömmlichen Ausgangstreiber zu realisieren, kann einem Transistor, beispielsweise dem Transistor 40, ein Inverter 42 vorgeschaltet sein.

Die zuletzt erläuterte Weiterbildung kann allein oder zusammen mit den Transistoren 20,21 realisiert sein.

## Patentansprüche

1. Schaltungsanordnung zum Schutz von Ausgängen (11) integrierter Schaltkreise (10), insbesondere CMOS-Schaltkreise, bei der zwischen Schaltkreis-Anschlüssen (11) und Versorgungspotential-Anschlüssen $(V_{ss}, V_{dd})$ Ableittransistoren (20,21) geschaltet sind, **dadurch gekennzeichnet**, daß die Ableittransistoren (20,21) vom gleichen Typ sind.

2. Schaltungsanordnung nach Anspruch 1, **da-durch gekennzeichnet**, daß die Ableittransi-storen Bipolar-Transistoren sind.

3. Schaltungsanordnung nach Anspruch 2, **da-durch gekennzeichnet**, daß die Ableittransi-storen npn-Transistoren sind.

4. Schaltungsanordnung nach Anspruch 1, **da-durch gekennzeichnet**, daß die Ableittransi-storen (20,21) MOS-Transistoren sind.

5. Schaltungsanordnung nach Anspruch 4, **da-durch gekennzeichnet**, daß die Ableittransi-storen (20,21) n-Kanal-Transistoren sind.

6. Schaltungsanordnung nach Anspruch 1 und/oder 2, **dadurch gekennzeichnet**, daß ein Ausgangstreiber des Schaltkreises (10) MOS-Transistoren (40,41) gleichen Kanal-Typs enthält und einem Transistor (40) ein Inverter (42) vorgeschaltet ist.

FIG 1

FIG 2

FIG 3

FIG 4